# EUROPEAN PATENT APPLICATION

(11) **EP 4 730 135 A1**
(43) Date of publication of application: **22.04.2026**
(21) Application number: 25177878.3
(22) Date of filing: 21.05.2025
(51) Int. Cl.: G06F 11/30, G06F 11/07

(54) **SYSTEMS AND METHODS FOR DEBUGGING AND PROFILING A MEMORY DEVICE**

(30) Priority: 17.10.2024 US 202463708673 P; 23.01.2025 US 202519035124
(71) Applicant: Samsung Electronics Co., Ltd., Suwon-si, Gyeonggi-do 16677 (KR)
(72) Inventor: LI, Zongwang, San Jose, CA, 95134 (US); PITCHUMANI, Rekha, San Jose, CA, 95134 (US); KI, Yang Seok, San Jose, CA, 95134 (US)
(74) Representative: Kuhnen & Wacker Patent- und Rechtsanwaltsbüro PartG mbB

(57) **Abstract**

Systems and methods for debugging and profiling a storage memory device are disclosed. The storage device (102) may include: a first memory medium (122) comprising a first region (122a) and a second region(122b); and a processor coupled to the first memory medium (122). The processor may be configured to: receive a first command from an application of a computing device, wherein the first command is associated with first data; identify an occurrence of a trigger condition; based on identifying the occurrence of the trigger condition, identify second data associated with the first data; and store the second data in the first region (122a), wherein the computing device (100) is configured to retrieve the second data from the first region (122a) for determining a state associated with the first data. It is also disclosed a corresponding method and a system comprising the storage device (102) and the computing device (100).

## Description

### FIELD

One or more aspects of embodiments according to the present disclosure relate to memory devices, and more particularly to debugging and profiling a memory device.

### BACKGROUND

Memory devices may be used for storing and reading data by one or more applications. Errors may occur during the process of storing and/or reading the data. It may be desirable to perform validation of the data to ensure, for example, that the data that is written to a memory device is the same data that is read from the memory device.

The above information disclosed in this Background section is only for enhancement of understanding of the background of the present disclosure, and therefore, it may contain information that does not form prior art.

### SUMMARY

One or more embodiments of the present disclosure are directed to a storage device comprising: a first memory medium comprising a first region and a second region; and a processor coupled to the first memory medium, the processor being configured to: receive a first command from an application of a computing device, wherein the first command is associated with first data; identify an occurrence of a trigger condition; based on identifying the occurrence of the trigger condition, identify second data associated with the first data; and store the second data in the first region, wherein the computing device is configured to retrieve the second data from the first region for determining a state associated with the first data.

According to one embodiment, the first memory medium includes volatile memory.

According to one embodiment, the second region is configured as cache memory, and the processor is configured to store the first data in the second region based on the first command.

According to one embodiment, the trigger condition includes detecting a second command from the computing device for setting a mode of the storage device to collect the second data.

According to one embodiment, the second data is output based on transmitting the first data to or from the first memory medium.

According to one embodiment, the first data is stored into a buffer and retrieved from the buffer during the transmitting of the first data, wherein the second data includes an output from the buffer.

According to one embodiment, the second data includes an output of the second region of the first memory medium.

According to one embodiment, the determining of the state of the first data includes: comparing the first data with the second data; and identifying a difference between the first data and the second data.

According to one embodiment, the processor is configured to: identify information about an operation performed by the storage device; and store the information in the first region, wherein the computing device is configured to retrieve the information for evaluating performance of the storage device.

According to one embodiment, the information includes a value indicative of a number of times the operation was performed.

One or more embodiments of the present disclosure are also directed to a method comprising: receiving, by a storage device, a first command from an application of a computing device, wherein the first command is associated with first data; identifying, by the storage device, occurrence of a trigger condition; based on identifying the occurrence of the trigger condition, identifying, by the storage device, second data associated with the first data; and storing, by the storage device, the second data in a first region of a first memory medium, wherein the computing device is configured to retrieve the second data from the first region for determining a state associated with the first data.

These and other features, aspects and advantages of the embodiments of the present disclosure will be more fully understood when considered with respect to the following detailed description, appended claims, and accompanying drawings.

### BRIEF DESCRIPTION OF THE DRAWINGS

Non-limiting and non-exhaustive embodiments of the present embodiments are described with reference to the following figures, wherein like reference numerals refer to like parts throughout the various views unless otherwise specified.
FIG. 1 depicts a block diagram of a debug and profiling system according to one or more embodiments;
FIG. 2 depicts a block diagram of a storage device comprising a storage controller according to one or more embodiments;
FIG. 3 depicts a conceptual layout diagram of memory nodes exposed to a host according to one or more embodiments;
FIG. 4 depicts a block diagram of various checkpoints that may be inserted in data flow paths through which data may traverse according to one or more embodiments;
FIG. 5 depicts a flow diagram of a debug process according to one or more embodiments;
FIG. 6 depicts a flow diagram of a profiling process according to one or more embodiments; and
FIG. 7 depicts a flow diagram of a process executed by a debug and profiling (D&P) engine according to one or more embodiments.

### DETAILED DESCRIPTION

Hereinafter, example embodiments will be described in more detail with reference to the accompanying drawings, in which like reference numbers refer to like elements throughout. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described. Unless otherwise noted, like reference numerals denote like elements throughout the attached drawings and the written description, and thus, descriptions thereof may not be repeated. Further, in the drawings, the relative sizes of elements, layers, and regions may be exaggerated and/or simplified for clarity.

Embodiments of the present disclosure are described below with reference to block diagrams and flow diagrams. Thus, it should be understood that each block of the block diagrams and flow diagrams may be implemented in the form of a computer program product, an entirely hardware embodiment, a combination of hardware and computer program products, and/or apparatus, systems, computing devices, computing entities, and/or the like carrying out instructions, operations, steps, and similar words used interchangeably (for example the executable instructions, instructions for execution, program code, and/or the like) on a computer-readable storage medium for execution. For example, retrieval, loading, and execution of code may be performed sequentially such that one instruction is retrieved, loaded, and executed at a time. In some example embodiments, retrieval, loading, and/or execution may be performed in parallel such that multiple instructions are retrieved, loaded, and/or executed together. Thus, such embodiments can produce specifically-configured machines performing the steps or operations specified in the block diagrams and flow diagrams. Accordingly, the block diagrams and flow diagrams support various combinations of embodiments for performing the specified instructions, operations, or steps.

In addition, a feature of embodiments of the present disclosure may be combined or combined with one or more other features, partially or entirely, and may be operated in various ways, and an embodiment may be implemented independently of one or more other embodiments, or in conjunction with the one or more other embodiments.

An application may access a memory device for storing and reading data to and from the device. Due to errors (e.g., data corruption) that may occur during the storing and/or reading of the data, the data that is stored may sometimes be inconsistent with the data that is read (referred to as a data mismatch). For example, the data flow for storing data to the memory device may start with the application, and flow to a kernel level, and from the kernel level to a driver (e.g., firmware) level. The driver may transmit the data over a memory interface to the memory device. Within the memory device, the data may be stored in one or more buffers before the data is ultimately stored in a memory medium (e.g., flash memory). Similarly, when data is retrieved from the memory medium, it may be stored in the one or more buffers, transmitted over the memory interface, flow from the driver level to the kernel level, and from the kernel level to the application requesting the data. Errors may occur at one or more points of the data path. For example, bit-flipping of the data may occur when the data is stored and retrieved to and from the buffers and/or memory medium. Such errors may result in a mismatch between the data that is written by the application, and the data that is retrieved by the application.

A debugging tool may be used to perform end-to-end validation of data (e.g., validation of data from the point when the data is generated and is transmitted via the data path, to the point when the data is read and returned to the application), to check for data consistency issues. Data consistency validation may be a challenging task. For example, data inconsistency may occur as a corner case (e.g., occur outside of normal operating parameters). It may take a substantial amount of time for an error in the storage device to occur before the corner case is triggered. Large amounts of data may need to be collected by the debugging tool until the data associated with the corner case is captured.

In addition, the debugging tool may use a customized port and/or protocol to capture and store the data for analysis and/or debugging. The use of a customized port and/or protocol may add extra hardware costs. The use of a customized port and/or protocol may also necessitate the addition of a host driver at the host computing device to support the debugging port.

In general terms, embodiments of the present disclosure are directed to systems and methods for debugging and profiling a memory device that uses a region of a memory medium to collect the debugging and profiling data (collectively referenced as debug data). In some embodiments, the memory medium is a host-managed device memory (HDM) that is mapped to an address space that is accessible to the host device. A portion of the HDM may be reserved to store debug data. The remainder of the HDM may be used to store data generated and used by an application of the host device.

In some embodiments, the memory device includes a debug or tracking unit (collectively referenced as a debug unit), and a profiling or performance unit (collectively referenced as a profiling unit). The debug unit may be configured to collect data at one or more points of a data path that the data may traverse as the data is written/read to/from the memory medium. The collected data may be stored in the debug region of the memory device. The one or more data path points may be associated with buffers, queues, or other memory devices that may cause error in the data (e.g., a bit flip) as the data is stored and retrieved from the memory devices. In some embodiments, the host device uses the debug data for determining the points in the data flow that resulted in the error. The host device or developers may take a corrective action based on the determination. The corrective action may include, for example, optimizing the scheduler or data path to avoid the device performance bottleneck based on profiling results, modifying/optimizing related device modules to resolving these errors due to corner cases, modifying error correction code usage, labeling a storage region as faulty, assigning new storage to a storage pool, and/or the like.

In some embodiments, the profiling unit is configured to monitor one or more data transactions, and increment one or more counters associated with the monitored data transactions. The profiling unit may increment the corresponding counters as the transactions are detected, such as, for example, a number of times data is written to a memory medium, a number of times data is evicted from the memory medium, a number of times data is merged prior to storing in the memory medium, and/or the like. The counter values may be stored in the debug region. The host device may use the counter values to evaluate performance of the storage device (e.g., internal hardware stack profiling). An optimization action may be taken based on the evaluation. The optimization action may include, for example, optimizing the scheduler or data path to avoid the device performance bottleneck based on profiling results, determining device failure, migrating to a new device, and/or the like.

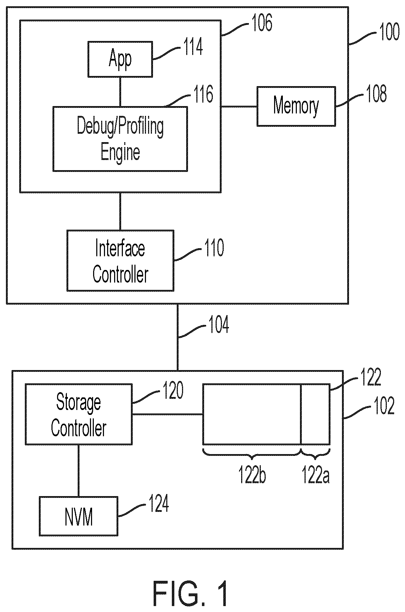

FIG. 1 depicts a block diagram of a debug and profiling system according to one or more embodiments. The system may include a host computing device (also referred to as "host" or "computing device") 100 coupled to an attached storage memory device (referred to as a storage device) 102 over one or more data communication links 104. In some embodiments, the data communication links 104 may include various general-purpose interfaces such as, for example, PCIe, Ethernet, Universal Serial Bus (USB), and/or any wired or wireless data communication link.

The host 100 may include a processor 106, primary memory 108, and host interface controller 110. The processor 106 may include one or more central processing unit (CPU) cores configured to run one or more applications 114 based on computer program instructions stored in the primary memory 108. The primary memory 108 may include volatile memory (e.g., random access memory (RAM)) and/or non-volatile memory (e.g., read only memory (ROM)). For example, the primary memory 108 may include a dynamic random access memory (DRAM) for storing the computer program instructions and/or data generated by the storage device 102.

The application 114 may be any application configured to transmit commands (e.g., load and store commands) to the storage device 102. For example, the application 114 may be a big data analysis application, e-commerce application, database application, machine learning application, and/or the like. Results of the data commands may be used by the application 114 to generate an output.

In some embodiments, the processor 106 further includes a debug and profiling engine 116 configured to transmit a command to place the storage device 102 in a debug mode. The debug and profiling engine 116 may also be configured to retrieve debug data collected by the storage device 102. The debug data may be collected over the data communications link 104 using the same type of commands that are used for retrieving non-debug data from the storage device. In this regard, no additional hardware (e.g., debug ports) or software (e.g., driver software) may be needed to retrieve the debug data.

The debug and profiling engine 116 may evaluate the retrieved data for data consistency validation, performance analysis, and/or other debug and profiling analysis. The debug and profiling analysis may be used to perform corrective and/or optimization actions. Such actions may include, for example optimizing the scheduler or data path to avoid the device performance bottleneck based on profiling results, modifying/optimizing related device modules to resolving these errors due to corner cases, modifying error correction code usage, labeling a storage region as faulty, assigning new storage to a storage pool, and/or the like.

The host interface controller 110 may include physical connections as well as software instructions which may be executed by the processor 106. In some embodiments, the host interface controller 110 allows the host 100 and the storage device 102 to send and receive data using a protocol such as, for example, NVMe, CXL, Cache Coherent Interconnect for Accelerators (CCIX), dual in-line memory module (DIMM) interface, Small Computer System Interface (SCSI), Non Volatile Memory Express (NVMe), Peripheral Component Interconnect Express (PCIe), remote direct memory access (RDMA) over Ethernet, Serial Advanced Technology Attachment (SATA), Fiber Channel, Serial Attached SCSI (SAS), NVMe over Fabric (NVMe-oF), iWARP protocol, InfiniBand protocol, 5G wireless protocol, Wi-Fi protocol, Bluetooth protocol, and/or the like.

In some embodiments, the host interface controller 110 is configured to receive data commands from the debug profiling engine 116, and forward the commands to the storage device 102. The commands may include commands to load/read data from the storage device 102, and commands to store/write data to the storage device. The commands may be generated in response to execution of an instruction by the application 114 that uses the data.

In some embodiments, the host interface controller 110 is configured to receive load commands from the debug and profiling engine 116. The load commands may be transmitted to the storage device 102 to retrieve debug data collected by the storage device.

The storage device 102 may take the form of a solid state drive (SSD), persistent memory, and/or the like. In some embodiments, the storage device 102 includes (or is embodied as) an SSD with cache coherency and/or computational capabilities.

In some embodiments, the storage device 102 includes a storage controller 120, storage memory 122, and non-volatile memory (NVM) 124. The storage memory 122 and NVM 124 may be configured as host-managed device memories (HDMs). In this regard, the NVM 124 and at least a portion of the storage 122 may be mapped to a system coherent address space and accessible to the host 100 via load and store commands.

The storage memory 122 may be high-performing memory of the storage device 102, and may include (or may be) volatile memory, for example, such as DRAM, but the present disclosure is not limited thereto, and the storage memory 122 may be any suitable kind of high-performing volatile or non-volatile memory. Although a single storage memory 122 is depicted for simplicity sake, a person of skill in the art should recognize that the storage device 102 may include other local memory for temporarily storing other data for the storage device.

In some embodiments, the storage memory 122 is configured to have two or more memory regions. In some embodiments, the storage memory 122 includes a debug region 122a (also referred to as a "first region") and a data cache region 122b (also referred to as a "second region"). The debug region 122a may have a first capacity and first base address that is exposed to the host 100 for retrieving debug data from the region. The host 100 may access the debug region 122a using load commands that adhere, for example, to the CXL protocol. In some embodiments, although the host 100 may access the debug region 122a to retrieve debug data from the region, the host may not store or write data into the region.

The data cache region 122b may have a second capacity and second base address. In some embodiments, the data cache region 122b is not exposed to the host. The data cache region 122b is used internally by the storage device 102 as cache memory. In this regard, the cache region 122b may store copies of data stored in the NVM 124. For example, data that is requested by the application 114 via a load command may be copied from the NVM 124 to the cache region 122b if not already there, for allowing the data to be retrieved from the cache region 122b instead of the NVM 124.

Although the embodiment of FIG. 1 depicts the storage memory 122 as having two regions, a person of skill in the art should recognize that the storage memory 122 may be configured to have more than two regions. For example, the storage memory 122 may have a region for storing debug data, a separate region for storing profiling data, and yet another region for storing cache data. Configuration information for the various regions may be provided to the host 100 via one or more registers. The registers may store the size and base address of the corresponding region. The regions may be mapped to the system address space and accessed by the host via the interface controller 110.

The NVM 124 may store data received, for example, from the host 100. The NVM 124 may include, for example, NAND flash memory, but the present disclosure is not limited thereto, and the NVM 124 may include any suitable kind of memory for storing the data (either persistently or non-persistently) according to an implementation of the storage device 102 (e.g., magnetic disks, tape, optical disks, and/or the like). In some embodiments, the capacity of the NVM 124 is larger than the capacity of the storage memory 122. In this regard, the storage device 102 may be referred to as a "memory expander" or "memory expansion device" (e.g., because a size of a memory is expanded using the NVM 124).

The storage controller 120 may be connected to the NVM 124 and the storage memory 122 over one or more storage interfaces. The storage controller 120 may receive data commands from the host 100, and transmit the commands to and from the NVM 124 and/or storage memory 122 for fulfilling the commands. In this regard, the storage controller 120 may include at least one processing component (also referred to as "processor") embedded thereon for interfacing with the host 100, the storage memory 122, and the NVM 124. The processing component may include, for example, a digital circuit (e.g., a microcontroller, a microprocessor, a digital signal processor, or a logic device (e.g., a field programmable gate array (FPGA), an application-specific integrated circuit (ASIC), and/or the like)) capable of executing data access instructions (e.g., via firmware and/or software) to provide access to and from the data (debug and non-debug data) stored in the storage memory 122 or NVM 124 according to the data access instructions.

In some embodiments, the storage controller 120 receives a command for placing the storage device 102 in a debug mode. The debug mode may allow the storage controller 120 to collect debug data into the debug region 122a while executing a data access instruction transmitted by the host 100. The debug data may be collected at one or more checkpoints. The checkpoints may be located at one or more locations of a data flow path traversed by the data that is loaded or stored by the storage device based on the data access instruction. The checkpoints may be selected to be points in the data flow where an error in the data may occur.

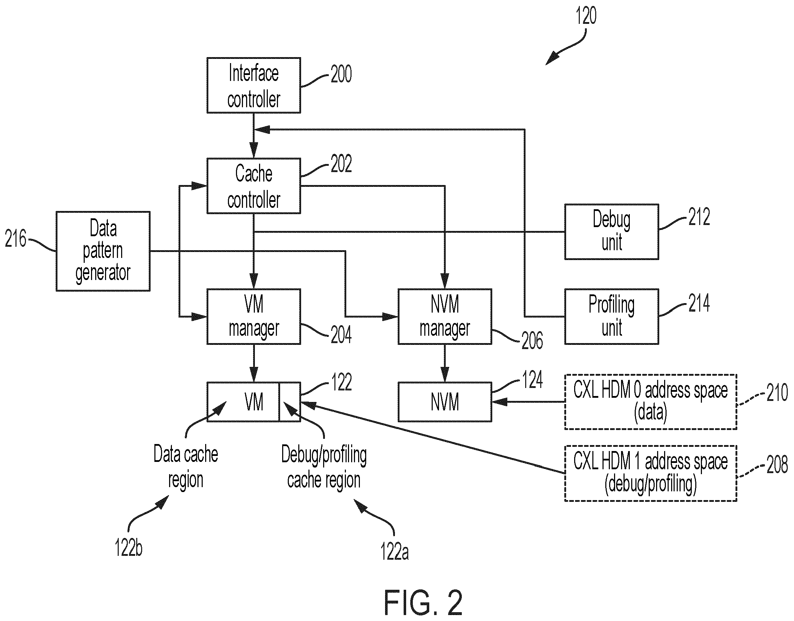

FIG. 2 depicts a block diagram of the storage device 102 comprising the storage controller 120 according to one or more embodiments. In some embodiments, the storage controller 120 includes a device interface controller 200 configured to receive commands from the host 100 (e.g., via the host interface controller 110). In this regard, the device interface controller 200 may include physical connections as well as software instructions for sending and receiving data to and from the host 100 using a protocol such as, for example, CXL, although embodiments are not limited thereto.

In some embodiments, the interface controller 200 receives data commands to load/store data from/to a specified memory address. The command may be received by a cache controller 202. The cache controller 202 may be configured to examine the address in the received command to determine whether the requested memory address is located in the debug region 122a. In some embodiments, the debug region 122a is configured and exposed to the host as an HDM 208 (e.g., HDM 1) with a first address space. The host 100 may be configured to load data from the first HDM, but may not be configured to write data to the first HDM.

If the received memory address (or range of memory addresses) is for the debug region 122a, the cache controller 202 issues a request to a volatile memory (VM) manager 204 (referenced as a memory manager or VM manager). The memory manager 204 in turn retrieves the requested debug data from the debug region 122a and returns the data to the debug and profiling engine 116.

If the cache controller 202 determines that the address in the received command is not in the debug region 122a, the command is processed as a data access command that is transmitted based on executing an application 114. In this regard, the cache controller 202 may determine whether the requested memory address is found in the data cache region 122b (e.g., a cache hit), and issue an appropriate request to the memory manager 204 or an NVM manager 206 depending on the determination. The requested memory address may be retrieved from the data cache region 122b or the NVM 124 via respectively the memory manager 204 or the NVM manager 206, and returned to the requesting application 114. In some embodiments, the NVM 124 is configured and exposed to the host 100 as a second HDM 210 (e.g., HDM 0) with a second address space. The host 100 may be configured to write and read data to and from the second HDM 210 during execution of the application 114.

In some embodiments, the storage controller 120 includes a debug unit 212, profiling unit 214, and data pattern generator 216. The debug unit 212 may be configured to receive a command from the debug/profiling engine 116 to set the storage device 120 in the debug mode. In response to the command, the debug unit 212 may monitor the flow of data as a load or store command for the data is processed.

For example, for a data store command, the debug unit 212 may monitor data that is received by the interface controller 200 from the host 100, and as the data flows through the cache controller 202, the VM manager 204, and into the data cache region 122b and the NVM 124. For a data load command, the debug unit 212 may monitor the data that is retrieved from the data cache region 122b or the NVM 124, and as the data flows through the VM manager 204 or the NVM manager 206, to the cache controller 202, and to the interface controller 200.

In some embodiments, data may be written into and out of one or more buffers as the data flows through the data path. The buffers may be included in the storage controller 120, and may provide temporary storage for different types of data as the load or store commands are processed. Errors may occur as the different data is written/read to/from the buffers. The debug unit 212 may be configured to capture, into the debug region 122a, data that is written/read into/out of the buffers, into/out of the data cache region 122b, and/or into/out of the NVM 124. In some embodiments, the debug unit 212 uses a sliding window to store data into the debug region 122a. In this regard, when the debug region becomes full, the sliding window pushes out old data in the debug region 122a to make room for new debug data.

In some embodiments, the profiling unit 214 is configured to gather profiling data for the storage device 102. In this regard, the profiling unit 214 may monitor transactions and/or resources of the storage device 102 and increment one or more counters associated with the monitored transactions or resources. For example, the profiling unit 214 may maintain one or more performance counters for monitoring a number of times data is written to a memory medium (e.g., memory 122 and/or NVM 124), a number of times data is evicted from the data cache region 122b, a number of times data is merged prior to storing the data in the data cache region 122b, and/or other types of transactions configured to be monitored by the profiling unit 214.

In some embodiments, the profiling unit 214 further monitors, via an associated counter, outstanding items in queues (e.g., DRAM cache write/read request queues, NAND read/write request queues, CXL read/write queues, etc.). In some embodiments, the profiling unit gathers other types of profiling data such as, for example, latency of outstanding items (e.g., using one or more timers), the round trip latency for a single request in a queue and the average latency for one request in a queue, and/or the like.

The profiling unit 214 may store the profiling data in the debug region 122a. In some embodiments, the profiling unit 214 tracks and collects the profiling data as the monitored transactions are detected, and stores the profiling data in the debug region 122a on a periodic (regular or irregular) basis. In some embodiments, the debug and profiling engine 116 retrieves the profiling data from the debug region 122a for evaluating storage device performance. For example, a level and timing of usage of different resources (e.g., buffers, cache, memory, etc.) of the storage device 102 may be determined, and optimization actions may be taken help improve performance of the storage device (e.g., bandwidth, throughput, etc.).

In some embodiments, the data pattern generator 216 may generate a data pattern (e.g., data that matches a data address that is subject to a load or store command), and provide the data pattern to the debug unit 212. In some embodiments, the debug unit 212 is configured to compare data captured at a checkpoint of a data flow path, against the data pattern provided by the data pattern generator 216, to make a data consistency evaluation (e.g., determine whether there is a data mismatch). The debug unit 212 may be configured to store the captured data in the debug region 122a based on detecting a mismatch.

In embodiments that do not include the data pattern generator 216, the debug unit 212 stores data as the data is captured at one or more checkpoints, and may not perform the data consistency evaluation before the data is stored.

Although one or more components of FIG. 2 are assumed to be separate components, a person of skill in the art will recognize that the functionality of the components may be combined or integrated into a single component, or further subdivided into further sub-components without departing from the scope of the inventive concept.

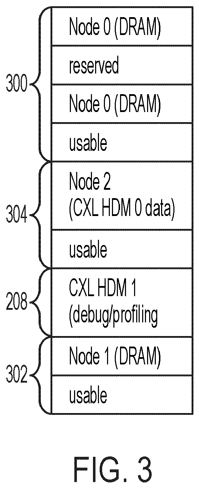

FIG. 3 depicts a conceptual layout diagram of memory nodes exposed to the host 100 according to one or more embodiments. In some embodiments, the host's primary memory 108 includes two DRAM nodes identified as Node 0 300 and Node 1 302 that are mapped to respectively a first address space and a second address space. The capabilities of the host's primary memory 108 may be expanded via a third node 304 that may be implemented via the NVM 124. The third node 304 may be configured and exposed to the host 100 as an HDM (e.g., HDM 210) that is mapped to a third address space. The third node 304 may be accessible for storing and loading data via, for example, the cxl.mem protocol.

In some embodiments, the debug region 122a is configured as a soft reserved memory region and exposed to the host 100 as a second HDM (e.g., HDM 208) that is mapped to a fourth address space. In some embodiments, the host is configured to read debug data from the debug region 122a. The debug region 122a, however, may not be used by the host 100 to write data.

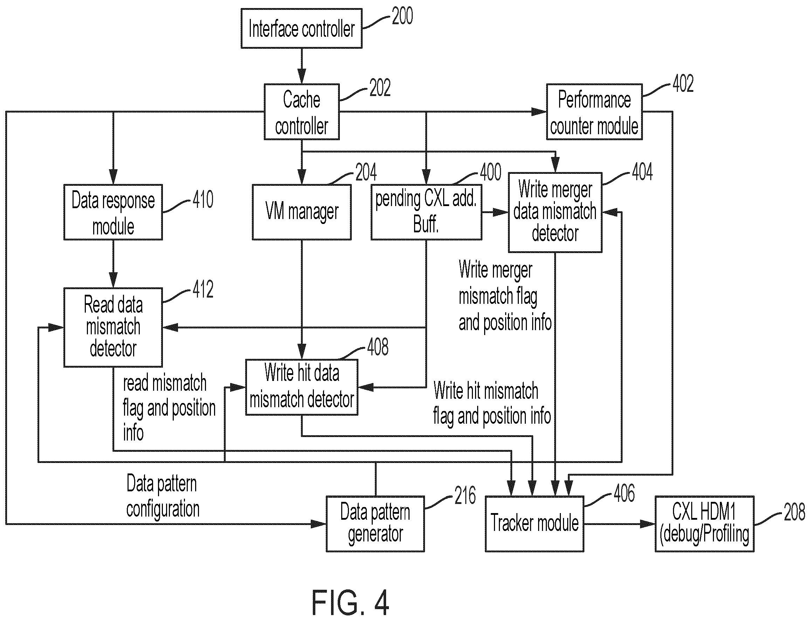

FIG. 4 depicts a block diagram of various checkpoints that may be inserted in data flow paths through which data may traverse according to one or more embodiments. For example, a data store command for storing host data may be received by the interface controller 200 and provided to the cache controller 202 for determining whether the host data is located in the data cache region 122b (e.g., a cache hit). An address associated with the host data may be stored in an address buffer 400 until the host data is ready to be processed for being stored.

In the event of a cache miss, contents of the requested data address may be retrieved from the NVM 124 and stored in a first temporary buffer. The host data to be stored may be identified based on the address in the address buffer 400 and stored in a second temporary buffer. The contents of the first temporary buffer and the second temporary buffer may be merged and stored in a third temporary buffer prior to storing the merged data in the data cache region 122b.

Errors may occur as data is stored and retrieved from the first, second, and/or third temporary buffers. For example, the host data that is to be stored may experience a bit flip or other data corruption when the data is retrieved from the second temporary buffer and merged with the contends of the first temporary buffer. In other examples, a data error may occur when the host data is merged with the data in the second temporary buffer, and/or when the merged data is retrieved from the third temporary buffer. Errors may also occur when data is written to a temporary buffer, but new data is written before the old data can be read out (e.g., when write actions are faster than read actions), causing a data mismatch. In yet other examples, data that is written to the data cache region 122b or the NVM 124 may be different from the data that is retrieved from these memory media (e.g., due to data corruption and other types of errors), causing a data mismatch.

In some embodiments, a checkpoint such as a write merge data mismatch detector 404 is inserted in a data path that traverses the first, second, and/or third temporary buffers for determining whether a data mismatch has occurred, and/or for collecting the data output from one or more corresponding buffers for debugging by the host 100. In this regard, a pattern of the host data, data retrieved from the NVM 124, and/or merged data to be stored may be generated by the data pattern generator 216 and compared with the output of the first, second, and/or third temporary buffers for determining a data mismatch. The output of the first, second, and/or third temporary buffers may be provided to a tracker module 406 of the debug unit 212 upon determining the data mismatch, and stored in a debug region 122a.

In some embodiments, the write merger data mismatch detector 404 provides a write merger mismatch flag and position information to the tracker module 406 for storing in the debug region 122a (e.g., in an address space associated with HDM 208). The position information may identify location in the data path where the data was collected, such as, for example, a checkpoint or buffer location.

In an embodiment where the storage device 102 does not include the data pattern generator 216, the write merge data mismatch detector 404 may simply collect the data that is output by the first, second, and/or third temporary buffers, and provide the collected data to the tracker module 406 without making the mismatch determination. Instead, the mismatch determination may be made by the host debugging and profiling engine 116.

In the event of a cache hit, and the address of the host data that is to be stored is found in the data cache region, the VM manager 204 may write the host data into the identified cache address. In some situations, however, the cache address provided by the VM manager 204 may be erroneous. Thus, in some embodiments, a checkpoint such as a write hit data mismatch detector 408 may be inserted in a data path that traverses the VM manager 204 for determining whether the identified cache address is correct and/or for writing the cache address identified by the VM manager 204 in the debug region 122a. In the event that a mismatch determination is made (e.g., by comparing a generated pattern against the cache address generated by the VM manager 204), a write hit mismatch flag and position information may be provided to the tracker module 406 for storing in the debug region 122a.

In some embodiments, the interface controller 200 receives a data load command for loading data from the data cache region 122b (e.g., for a cache hit) or the NVM 124 (e.g., for a cache miss). A data response module 410 of the storage controller 120 may be configured to provide the requested data to the host 100. In some situations, however, the data that is retrieved based on the identified address may differ from the data that was previously written to the address, resulting in a data mismatch.

In some embodiments, a checkpoint such as a read data mismatch detector 412 is inserted in a data path that traverses the data response module 410 for determining whether a data mismatch has occurred, and/or for writing the retrieved data and its address into the debug region 122a. In the event that a mismatch determination is made (e.g., by comparing the retrieved data against the data that was previously written), a read mismatch flag and position information may be provided to the tracker module 406 for storing in the debug region 122a. In some embodiments, the debug data is stored in the debug region 122a without first making the mismatch determination (e.g., in embodiments that do not include the data pattern generator).

In some embodiments, the cache controller 202 may transmit a signal to a performance counter module 402 (e.g., within the profiling unit 214) for incrementing one or more counters based on a received command. For example, the performance counter module 402 may increment a write counter based on the store command, a read counter based on a load command, and/or the like. The counter information may be provided to the tracker module 406 for storing in the debug region 122a. The debugging and profiling engine 116 may be configured to analyze the counter values for evaluating performance of the storage device 102.

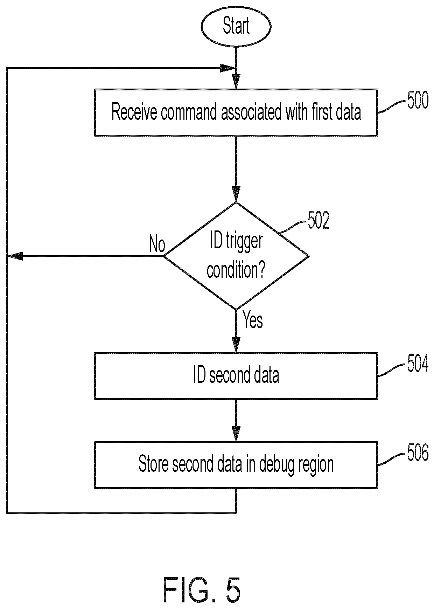

FIG. 5 depicts a flow diagram of a debug process according to one or more embodiments. The process starts, and in act 500, the storage controller 120 receives a command associated with first data. The first command may be a data load or store command transmitted by a computing device (e.g., the host 100) based on running an application.

In act 502, the storage controller 120 determines whether a trigger condition has been identified. The trigger condition may be identified, for example, based on identifying a command from the host 100 (e.g., by the debug and profiling engine 116) to place the storage device 102 in a debug mode. In some embodiments, the trigger condition is identified based on detecting a checkpoint in a data path of the first data as the data is transmitted to or from a first memory medium (e.g., the data cache region 122b or NVM 124).

If the trigger condition has been identified, the storage controller 120 (e.g., the debug unit 212) identifies, at act 504, second data (e.g., debug data) associated with the first data. The second data may be data captured at a checkpoint. For example, the second data may be the output of one or more buffers in the data path as the first data goes in and out of the buffers while traversing the data path. In another example, the second data may be the output of a second region (e.g., the data cache region 122b) of the first memory medium.

In act 506, the storage controller 120 stores the second data in a first region (e.g., the debug region 122a) of the first memory medium. The computing device (e.g., the debug and profiling engine 116) may retrieve the second data from the first region for determining an attribute or state (e.g., data consistency) associated with the first data. In some embodiments, the determining of the attribute or state includes comparing the first data with the second data, and identifying a difference (e.g., mismatch) between the first data and the second data.

A processor of the storage controller 120 may be configured to perform the method of FIG. 5.

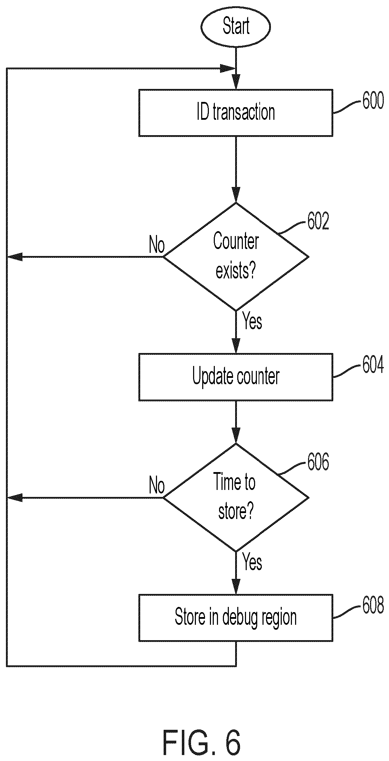

FIG. 6 depicts a flow diagram of a profiling process according to one or more embodiments. The process starts, and in act 600, the storage controller 120 (e.g., the profiling unit 214) identifies a transaction or operation that the profiling unit 214 is configured to monitor. In this regard, commands received by the interface controller 200, such as, for example, data store and load commands, are transmitted to the profiling unit 214. Information of other operations may also be transmitted to the profiling unit 214, such as, for example, operations performed by the cache controller 202. Such operations may include, for example, data eviction operations, data merger operations, data caching operations, and/or the like.

In act 602, the profiling unit 214 determines whether a counter or other measurement tool (e.g., a timer) is configured for the identified transaction or operation.

If the answer is YES, the profiling unit 214 updates, in act 604, the associated counter or measurement tool. For example, a write counter may be increased upon detecting a write command, an eviction counter may be incremented upon detecting an eviction command, and/or the like.

In act 606, a determination is made as to whether the collected counter values should be stored in the debug region 122a. In this regard, the storing of the counter values may occur periodically at regular or irregular intervals.

If the answer is YES, the one or more counter values are stored in the debug region 122a in act 608.

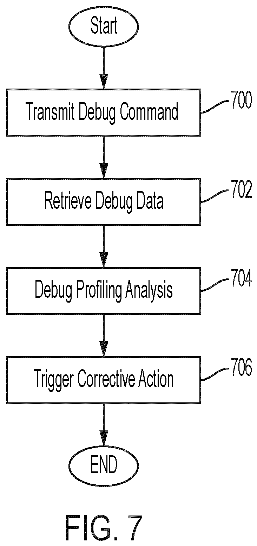

FIG. 7 depicts a flow diagram of a process executed by the debug and profiling (D&P) engine 116 according to one or more embodiments. The process starts, and in act 700, the D&P engine 116 transmits a debug command to the storage device 102 for placing the storage device in a debug mode. The debug command may be transmitted based on detecting a trigger condition, such as, for example, based on detecting a threshold number of data consistency errors, detecting decreased performance of the storage device (e.g., access time above a maximum threshold), and/or the like.

In act 702, the D&P engine 116 retrieves the debug and profiling data stored in the debug region 122a. In this regard, the D&P engine 116 accesses one or more memory addresses that are mapped to the debug region 122a. The access may be via a data load command. In this regard, no extra hardware or software drivers may be needed for retrieving the debug data. The same type of command (e.g., a CXL load command) that is used to retrieve non-debug data from the NVM 124 may be used for retrieving the debug data from the debug region 122a.

In act 704, the D&P engine analyzes the retrieved debug data for performing a debugging or profiling operation. The debugging operation may include comparing expected data against data that is logged in the debug region 122a for determining a data mismatch. The profiling operation may include evaluating storage device performance based on retrieved counter values. The performance evaluation may include, for example, determining latency, throughput, cache hit rate, and/or the like, of the storage device.

In act 706, a correction action is taken based on detecting the data mismatch for a debug operation. For example, the location (e.g., a buffer or checkpoint on the data path) that generated the mismatched data may be identified, and the faulty module is identified and modified/corrected. For a profiling operation, the action that may be taken may include an optimization action for improving performance of the storage device 102.

As a person of skill in the art should appreciate, embodiments of the present disclosure allow debug data to be collected and analyzed with no specialized hardware (e.g., debug ports) or associated software (e.g., driver software) or protocol. The host 100 may access data collected by the storage device in an HDM debug address region as it would any other data. In some embodiments, the host may access the debug data via CXL load commands for further analysis and debugging. Profiling data may similarly be stored in the debug address region and accessed by the host 100 for performance analysis and optimization.

One or more embodiments of the present disclosure may be implemented in one or more processors. The term processor may refer to one or more processors and/or one or more processing cores. The one or more processors may be hosted in a single device or distributed over multiple devices (e.g. over a cloud system). A processor may include, for example, application specific integrated circuits (ASICs), general purpose or special purpose central processing units (CPUs), digital signal processors (DSPs), graphics processing units (GPUs), and programmable logic devices such as field programmable gate arrays (FPGAs). In a processor, as used herein, each function is performed either by hardware configured, i.e., hard-wired, to perform that function, or by more general-purpose hardware, such as a CPU, configured to execute instructions stored in a non-transitory storage medium (e.g. memory). A processor may be fabricated on a single printed circuit board (PCB) or distributed over several interconnected PCBs. A processor may contain other processing circuits; for example, a processing circuit may include two processing circuits, an FPGA and a CPU, interconnected on a PCB.

It will be understood that, although the terms "first", "second", "third", etc., may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed herein could be termed a second element, component, region, layer or section, without departing from the scope of the inventive concept.

The terminology used herein is for the purpose of describing particular embodiments only and is not intended to be limiting of the inventive concept. Also, unless explicitly stated, the embodiments described herein are not mutually exclusive. Aspects of the embodiments described herein may be combined in some implementations.

As used herein, the terms "substantially," "about," and similar terms are used as terms of approximation and not as terms of degree, and are intended to account for the inherent deviations in measured or calculated values that would be recognized by those of ordinary skill in the art.

As used herein, the singular forms "a" and "an" are intended to include the plural forms as well, unless the context clearly indicates otherwise. It will be further understood that the terms "comprises" and/or "comprising", when used in this specification, specify the presence of stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. Expressions such as "at least one of," when preceding a list of elements, modify the entire list of elements and do not modify the individual elements of the list. Further, the use of "may" when describing embodiments of the inventive concept refers to "one or more embodiments of the present disclosure". Also, the term "exemplary" is intended to refer to an example or illustration. As used herein, the terms "use," "using," and "used" may be considered synonymous with the terms "utilize," "utilizing," and "utilized," respectively.

Although exemplary embodiments of systems and methods for debugging and profiling a memory device have been specifically described and illustrated herein, many modifications and variations will be apparent to those skilled in the art. Accordingly, it is to be understood that systems and methods for debugging and profiling a memory device constructed according to principles of this disclosure may be embodied other than as specifically described herein. The disclosure is also defined in the following claims, and equivalents thereof.

The systems and methods for debugging and profiling a memory device may contain one or more combination of features set forth in the below statements.

Statement 1. A storage device comprising: a first memory medium comprising a first region and a second region; and a processor coupled to the first memory medium, the processor being configured to: receive a first command from an application of a computing device, wherein the first command is associated with first data; identify an occurrence of a trigger condition; based on identifying the occurrence of the trigger condition, identify second data associated with the first data; and store the second data in the first region, wherein the computing device is configured to retrieve the second data from the first region for determining a state associated with the first data.

Statement 2. The storage device of Statement 1, wherein the first memory medium includes volatile memory.

Statement 3. The storage device of Statement 2, wherein the second region is configured as cache memory, and the processor is configured to store the first data in the second region based on the first command.

Statement 4. The storage device of Statement 1 wherein the trigger condition includes detecting a second command from the computing device for setting a mode of the storage device to collect the second data.

Statement 5. The storage device of Statement 1, wherein the second data is output based on transmitting the first data to or from the first memory medium.

Statement 6. The storage device of Statement 5, wherein the first data is stored into a buffer and retrieved from the buffer during the transmitting of the first data, wherein the second data includes an output from the buffer.

Statement 7. The storage device of Statement 5, wherein the second data includes an output of the second region of the first memory medium.

Statement 8. The storage device of Statement 1, wherein the determining of the state of the first data includes: comparing the first data with the second data; and identifying a difference between the first data and the second data.

Statement 9. The storage device of Statement 1, wherein the processor is configured to: identify information about an operation performed by the storage device; and store the information in the first region, wherein the computing device is configured to retrieve the information for evaluating performance of the storage device.

Statement 10. The storage device of Statement 9, wherein the information includes a value indicative of a number of times the operation was performed.

Statement 11. A method comprising: receiving, by a storage device, a first command from an application of a computing device, wherein the first command is associated with first data; identifying, by the storage device, occurrence of a trigger condition; based on identifying the occurrence of the trigger condition, identifying, by the storage device, second data associated with the first data; and storing, by the storage device, the second data in a first region of a first memory medium, wherein the computing device is configured to retrieve the second data from the first region for determining a state associated with the first data.

Statement 12. The method of Statement 11, wherein the first memory medium includes volatile memory.

Statement 13. The method of Statement 12, wherein a second region of the first memory medium is configured as cache memory, and the method further includes: storing the first data in the second region based on the first command.

Statement 14. The method of Statement 11 wherein the trigger condition includes detecting a second command from the computing device for setting a mode of the storage device to collect the second data.

Statement 15. The method of Statement 11, wherein the second data is output based on transmitting the first data to or from the first memory medium.

Statement 16. The method of Statement 15, wherein the first data is stored into a buffer and retrieved from the buffer during the transmitting of the first data, wherein the second data includes an output from the buffer.

Statement 17. The method of Statement 15, wherein the second data includes an output of a second region of the first memory medium.

Statement 18. The method of Statement 11, wherein the determining of the state associated with the first data includes: comparing the first data with the second data; and identifying a difference between the first data and the second data.

Statement 19. The method of Statement 11 further comprising: identifying information about an operation performed by the storage device; and storing the information in the first region, wherein the computing device is configured to retrieve the information for evaluating performance of the storage device.

Statement 20. The method of Statement 19, wherein the information includes a value indicative of a number of times the operation was performed.

## Claims

1. A method comprising:
receiving, by a storage device (102), a first command from an application of a computing device (100), wherein the first command is associated with first data;
identifying, by the storage device (102), occurrence of a trigger condition;
based on identifying the occurrence of the trigger condition, identifying, by the storage device (102), second data associated with the first data; and
storing, by the storage device (102), the second data in a first region (122a) of a first memory medium (122), wherein the computing device (100) is configured to retrieve the second data from the first region (122a) for determining a state associated with the first data.

2. The method of claim 1, wherein the first memory medium (122) includes volatile memory.

3. The method of claim 1 or 2, wherein a second region (122b) of the first memory medium (122) is configured as cache memory, and the method further includes:
storing the first data in the second region (122b) based on the first command.

4. The method of any one of claims 1 to 3, wherein the trigger condition includes detecting a second command from the computing device for setting a mode of the storage device (102) to collect the second data.

5. The method of any one of claims 1 to 4, wherein the second data is output based on transmitting the first data to or from the first memory medium (122).

6. The method of claim 5, wherein the first data is stored into a buffer and retrieved from the buffer during the transmitting of the first data, wherein the second data includes an output from the buffer.

7. The method of claim 5, wherein the second data includes an output of a second region (122b) of the first memory medium (122).

8. The method of any one of claims 1 to 7, wherein the determining of the state associated with the first data includes:
comparing the first data with the second data; and
identifying a difference between the first data and the second data.

9. The method of any one of claims 1 to 8 further comprising:
identifying information about an operation performed by the storage device (102); and
storing the information in the first region (122), wherein the computing device (100) is configured to retrieve the information for evaluating performance of the storage device (102).

10. The method of claim 9, wherein the information includes a value indicative of a number of times the operation was performed.

11. A storage device (102) comprising:
a first memory medium (122) comprising a first region (122a) and a second region (122b); and
a processor coupled to the first memory medium (122), the processor being configured to perform the method according to any one of claims 1 to 10.

12. The storage device of claim 11, wherein the first memory medium (122) includes volatile memory.

13. The storage device of claim 11 or 12, wherein the second region (122b) is configured as cache memory, and the processor is configured to store the first data in the second region (122b) based on the first command.

14. A system, comprising:
the storage device of any one of claims 11 to 13; and
a computing device (100) configured to retrieve the second data from the first region (122a) for determining a state associated with the first data.

## Amended claims

### Amended claims in accordance with Rule 137(2) EPC.

1. A method comprising:
receiving, by a storage device (102), a first command from an application of a computing device (100), wherein the first command is associated with first data;
identifying, by the storage device (102), occurrence of a trigger condition;
based on identifying the occurrence of the trigger condition, identifying, by the storage device (102), second data associated with the first data; and
storing, by the storage device (102), the second data in a first region (122a) of a first memory medium (122), wherein the computing device (100) is configured to retrieve the second data from the first region (122a) for determining a state associated with the first data,
wherein the trigger condition includes detecting a second command from the computing device for setting a mode of the storage device (102) to collect the second data.

2. The method of claim 1, wherein the first memory medium (122) includes volatile memory.

3. The method of claim 1 or 2, wherein a second region (122b) of the first memory medium (122) is configured as cache memory, and the method further includes:
storing the first data in the second region (122b) based on the first command.

4. The method of any one of claims 1 to 3, wherein the second data is output based on transmitting the first data to or from the first memory medium (122).

5. The method of claim 4, wherein the first data is stored into a buffer and retrieved from the buffer during the transmitting of the first data, wherein the second data includes an output from the buffer.

6. The method of claim 4, wherein the second data includes an output of a second region (122b) of the first memory medium (122).

7. The method of any one of claims 1 to 6, wherein the determining of the state associated with the first data includes:
comparing the first data with the second data; and
identifying a difference between the first data and the second data.

8. The method of any one of claims 1 to 7 further comprising:
identifying information about an operation performed by the storage device (102); and
storing the information in the first region (122), wherein the computing device (100) is configured to retrieve the information for evaluating performance of the storage device (102).

9. The method of claim 8, wherein the information includes a value indicative of a number of times the operation was performed.

10. A storage device (102) comprising:
a first memory medium (122) comprising a first region (122a) and a second region (122b); and
a processor coupled to the first memory medium (122), the processor being configured to perform the method according to any one of claims 1 to 9.

11. The storage device of claim 10, wherein the first memory medium (122) includes volatile memory.

12. The storage device of claim 10 or 11, wherein the second region (122b) is configured as cache memory, and the processor is configured to store the first data in the second region (122b) based on the first command.

13. A system, comprising:
the storage device of any one of claims 10 to 12; and
a computing device (100) configured to retrieve the second data from the first region (122a) for determining a state associated with the first data.
